# EUROPÄISCHE PATENTSCHRIFT

(11) **EP 1 300 951 B1**
(45) Veröffentlichungstag und Bekanntmachung des Hinweises auf die Patenterteilung: **26.09.2007**
(21) Anmeldenummer: 02021937.4
(22) Anmeldetag: 29.09.2002
(51) Int. Cl.: H03M 3/02

(54) **Delta-Sigma Analog/Digital-Wandler**
Delta-sigma analogue/digital converter
Convertisseur analogique-numérique du type delta-sigma

(30) Priorität: 02.10.2001 DE 20116222 U; 02.10.2001 DE 10148799
(43) Veröffentlichungstag der Anmeldung: 09.04.2003
(73) Patentinhaber: Gude, Michael, Dr., 50169 Kerpen (DE)
(72) Erfinder: Gude, Michael, Dr., 50169 Kerpen (DE)

(56) Entgegenhaltungen:
- EP-A- 0 989 678
- DE-A- 19 518 508
- KUHN J A ET AL: "Mixed signal ASIC design issues and methodologies" IEEE, 25. September 1989 (1989-09-25), Seiten T4-1-1-9, XP010092528
- LAMPINEN H ET AL: "A low-voltage, multibit sigma-delta modulator for wideband applications" DESIGN OF MIXED-MODE INTEGRATED CIRCUITS AND APPLICATIONS, 1999. THIRD INTERNATIONAL WORKSHOP ON PUERTO VALLARTA, MEXICO 26-28 JULY 1999, PISCATAWAY, NJ, USA,IEEE, US, 26. Juli 1999 (1999-07-26), Seiten 138-142, XP010376248 ISBN: 0-7803-5588-1
- ANALOG DEVICES: "Practical Analog Design Techniques" ANALOG DEVICES, 1995, Seiten 4-51-4-56,

## Beschreibung

Nach dem Stand der Technik sind Analog/Digital-Wandler (A/D-Wandler) seit langem bekannt. Sie wandeln ein analoges Eingangssignal in Form einer Eingangsspannung in ein in der Regel binäres Ausgangssignal um. Dabei folgt der digitale Ausgangswert in der Regel linear der Eingangsspannung.

Seit einigen Jahren sind sog. Delta-Sigma A/D-Wandler bekannt, die durch Überabtastung des Eingangssignals unter Zuhilfenahme von Integratoren, Komperatoren und digitalen Filtern das Eingangssignal in ein digitales Ausgangssignal umsetzen. Beschreibungen zum Prinzip und verschiedenen Realisierungen finden sich in:
(1) Delta-Sigma Data Converters : Theory, Design, and Simulation von Steven R. Norsworthy, u. a. ISBN: 0780310454 (1996)

Vorteil der Delta-Sigma A/D-Wandler ist die relative Unempfindlichkeit gegen gewisse Unzulänglichkeiten und Toleranzen des analogen Teils.

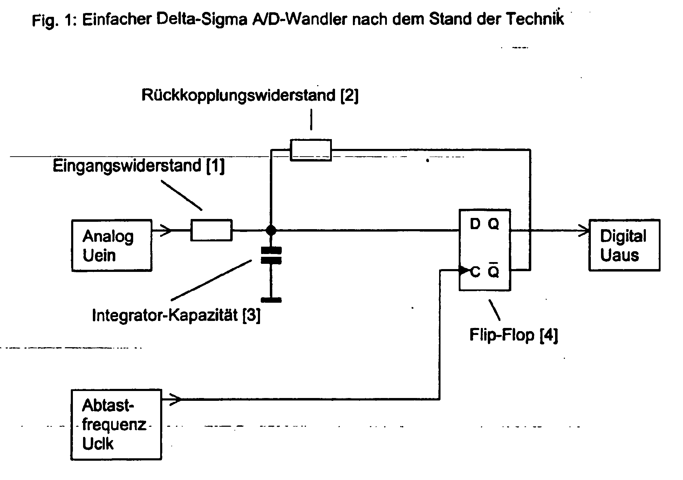

Nach der deutschen Offenlegungsschrift (D1) DE 195 18 508 A1 und der japanischen Patentschrift JP 10-2734731 B2 sind Delta-Sigma A/D-Wandler gemäß dem Oberbegriff des Patentanspruchs 1. bekannt, die im analogen Frontend lediglich zwei Widerstände und eine Integrator-Kapazität benötigen. Darüber hinaus wird nur eine rein digitale integrierte Schaltung benötigt. (Fig. 1)

Aus der Druckschrift (D2) "Practical Analog Design Techniques", Analog Devices 1995, sind auf den Seiten 4-51 bis 4-56 diverse Techniken beschrieben, um analoge Schaltungsteile von digitalen Schaltungsteilen zu trennen. Hier ist eine Vielzahl aufwendiger Maßnahmen beschrieben. Die vorliegende Erfindung zeichnet sich gerade dadurch aus, dass hier nur ein Bruchteil der Maßnahmen zur Anwendung gelangen.

Um die Wandlung auch geringer Eingangsspannungen zu ermöglichen, sollte der Spannungshub am Eingang des FF (Fig. 1) in der Größenordnung der aufbaubedingten Störspannungen und des Eingangsrauschens verbleiben. Unter aufbaubedingten Störspannungen sind insbesondere Signaleinstreuungen von benachbarten Schaltungen und Störspannungen auf den Versorgungsleitungen des Flip-Flops (FFs) zu verstehen.

Da bei den sehr einfachen Delta-Sigma A/D-Wandlern die Versorgungsspannung als Referenz-Spannung genutzt wird, ist die Qualität, d.h. Auflösung des Wandlers direkt abhängig von der Qualität der Versorgungsspannung. Ohne weitere Maßnahmen ist deshalb eine A/D-Wandlung mit einer Auflösung von etwa 7 Bit möglich, was ebenfalls der Offenlegungsschrift (2) zu entnehmen ist.

Der vorliegenden Erfindung liegt die Aufgabe zu Grunde, den analogen Teil eines Delta-Sigma A/D-Wandlers (analoges Frontend) soweit zu verbessern, dass bei Beibehaltunng des einfachen Aufbaus eine erhebliche Steigerung der Auflösung möglich wird. Angestrebt ist hierbei eine Auflösung von mindestens 13 Bit, da diese für gängige Audio-Codecs benötigt wird.

Diese Aufgabe wird erfindungsgemäß dadurch gelöst, dass ein vor dem D-Eingang des D-Flip-Flops [4] befindlicher erster Buffer [5][7] und/oder ein hinter dem Ausgang des D-Flip-Flops [4] befindlicher zweiter Buffer [6][8] betriebsspannungsmäßig getrennt von digitalen Schaltungsteilen, die sich auf dem Halbleiterchip befinden, versorgt wird, damit eine Entkopplung zwischen Halbleiterchip und analogem Frontend eintritt.

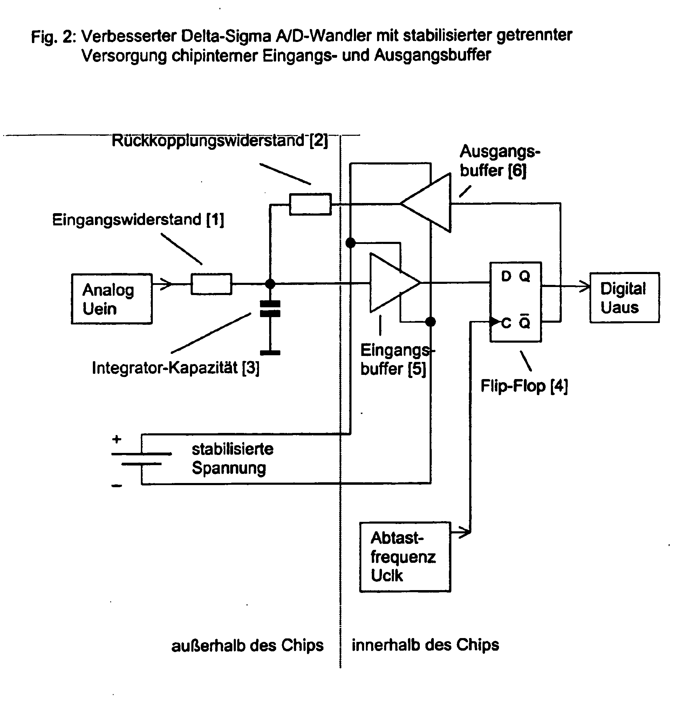

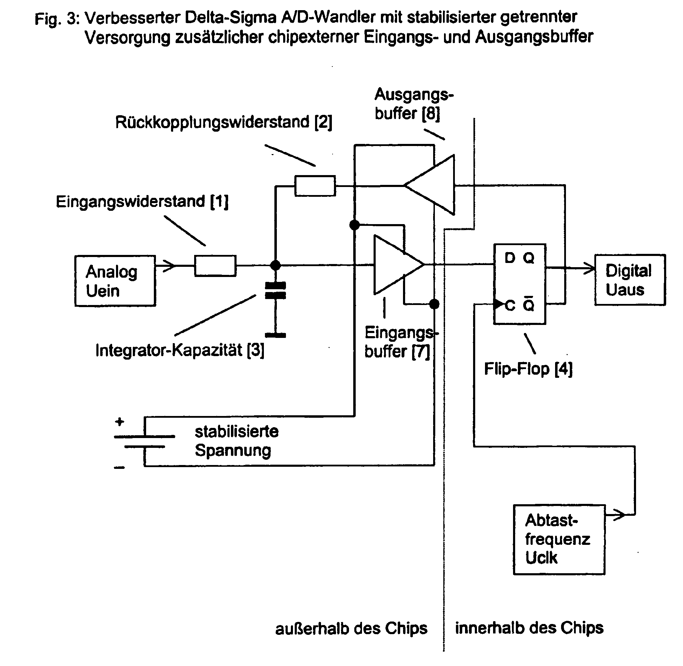

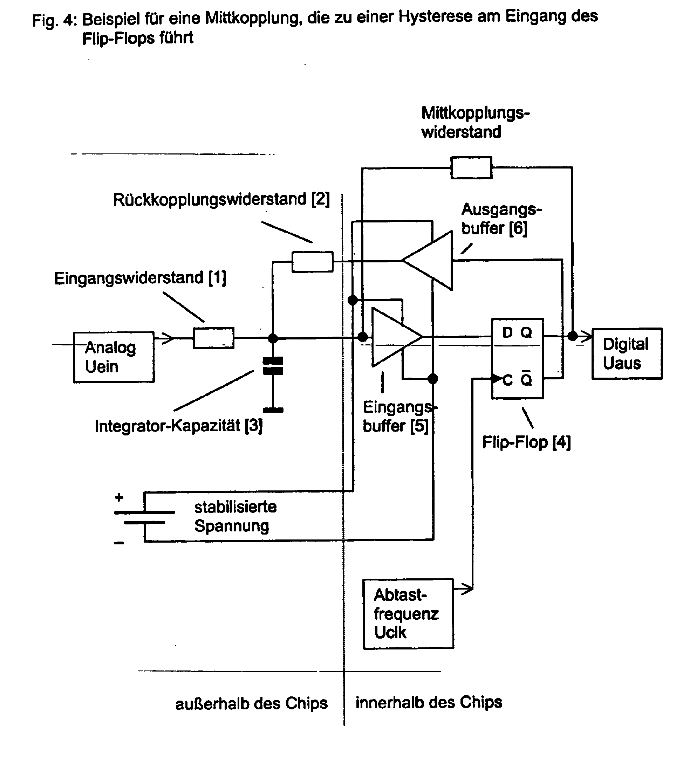

Fig. 2 und Fig. 3 zeigen Ausführungsbeispiele, wobei Fig. 2 die Chip-internen Buffer [5] und [6] zeigt, während Fig. 3 externe Buffer zeigt.

Durch eine getrennte gut stabilisierte und entstörte Versorgungsspannung kann der negative Einfluss der digitalen Halbleiterschaltung wie auch andere negative Störeinflüsse vom analogen Frontend ferngehalten werden, was zu einer erheblichen Auflösungssteigerung des A/D-Wandlers führt (Fig. 2).

Nach Anspruch 2. wird definiert, dass sich der erste Buffer [5] und/oder der zweite Buffer [6] auf dem Halbleiterchip befinden bzw. befindet und durch, vom Rest des Halbleiterchips getrennt angeschlossene, Versorgungsspannungsleitungen versorgt werden/wird.

Nach Anspruch 3. wird definiert, dass der erste Buffer und/oder der zweite Buffer jeweils ein externer Buffer [7,8] ist, deren/dessen Betriebsspannung getrennt von der Betriebsspannung für die digitalen Schaltungsteile des Halbleiterchips stabilisiert wird, damit eine Entkopplung zwischen Halbleiterchip und analogem Frontend eintritt. (Fig. 3)

Durch die geschilderten Maßnahmen ist es möglich eine Auflösung bis in den Bereich von 16 Bit zu erreichen.

Um hohe Geschwindigkeiten bei hoher Auflösung des Delta-Sigma A/D-Wandlers zu erreichen, müssen nach (1) hohe Taktfrequenzen für das Flip-Flop [4] gewählt werden. Dieses ist innerhalb eines digitalen Halbleiterchips auch relativ einfach möglich. Sobald jedoch die Signale über Buffer das Chip verlassen sollen, treten eine Vielzahl zusätzlicher Probleme wie elektromagnetische Verträglichkeit, zusätzliche Stromaufnahme etc. auf. Deshalb ist anzustreben, dass das Ausgangssignal des Flip-Flops [4] in seiner Frequenz deutlich unter seiner Abtastfrequenz liegt. Diese Abtastfrequenz kann rein intern auf dem Chip erzeugt werden, so dass eine Abstrahlung dieser Frequenz weitestgehend entfällt. So können mit heutigen Technologien z.B. Rückkopplungsspannungen von einigen MHz bei Abtastfrequenzen von bis zu einem GigaHz erreicht werden.

Der Patentschrift (3) US 6,232,902 B1 ist zu entnehmen, dass es aus Gründen der Stromaufnahme und anderer Anwendungsbedingungen auch vorteilhaft sein kann, die Frequenz des Ausgangssignal des Flip-Flops zu begrenzen. So schlägt (3) eine aufwendige Schaltung mit Timern vor, um die maximale Frequenz des Flip-Flop-Ausgangssignals zu begrenzen. Hier zeigt die vorliegende Erfindung eine einfachere Lösung.

Nach den Ansprüchen 4. und 5. kann der erfindungsgemäße Delta-Sigma-A/D-Wandler so realisiert werden, dass die über den Rückkopplungswiderstand [2] zurückgeführte Ausgangsspannung des D-Flip-Flops [4] frequenzmäßig deutlich unter der Abtastfrequenz dieses Flip-Flops liegt. Dieses tritt immer dann ein, wenn der aus Rückkopplungswiderstand [2] und Integrator-Kapazität [3] zusammengesetzte Tiefpass derart dimensioniert ist, dass eine Änderung der Ausgangsspannung des FFs nicht innerhalb eines Taktes auf die Eingangsspannung rückwirkt (Anspruch 4.). Das gleiche Verhalten wird auch durch minimale interne Mitkopplungen im Signalpfad erreicht. Diese führen zu einer geringen Hysterese des Eingangspfads des FFs (Anspruch 5.)

Die Anordnung ist dadurch von Vorteil, da die zeitliche Auflösung der Rückkopplungsspannung im wesentlichen von der Abtastfrequenz des D-Flip-Flops [4] abhängt. Diese Zeitauflösung bleibt auch bei Verringerung der Ausgangsfrequenz des Flip-Flops erhalten.

Nach Anspruch 6. kann die Abtastfrequenz für das D-Flip-Flop [4] einem nicht frequenzstabilisierten Oszillator entnommen werden. Hohe, nicht frequenzstabilisierte Frequenzen, im oberen Megahertz oder Gigahertz-Bereich lassen sich mit sog. Ringoszillatoren auf einem Chip leicht erzeugen. Diese sind in ihrer Frequenz jedoch von der Versorgungsspannung, der Temperatur und von Fertigungstoleranzen abhängig. Trotzdem können sie als Abtastfrequenz für das D-Flip-Flop [4] dienen. Für die Einhaltung der gewünschten Qualität des A/D-Wandlers ist nur darauf zu achten, dass eine Mindestfrequenz eingehalten wird. Höhere Abtastfrequenzen verbessern die Eigenschaften des A/D-Wandlers nur. Soll die Ausgangsdatenrate eine feste Frequenz haben, so kann die Datenrate im Digitalteil innerhalb eines Dezimators oder eines digitalen Filters auf eine konstante Frequenz umgesetzt werden.

## Patentansprüche

1. Delta-Sigma Analog-/Digital-Wandler, dessen analoges Frontend aus einem Eingangswiderstand [1], einem Rückkopplungswiderstand [2] einer Integrator-Kapazität [3] besteht, der ein D-Flip-Flop [4]auf einem Halbleiterchip enthält, **dadurch gekennzeichnet,**
**dass** ein vor dem D-Eingang des D-Flip-Flops [4] befindlicher erster Buffer [5][7] und/oder ein hinter dem Ausgang des D-Flip-Flops [4] befindlicher zweiter Buffer [6][8] betriebsspannungsmäßig getrennt von digitalen Schaltungsteilen, die sich auf dem Halbleiterchip befinden, versorgt wird, damit eine Entkopplung zwischen Halbleiterchip und analogem Frontend eintritt.

2. Delta-Sigma Analog-/Digital-Wandler nach Anspruch 1, **dadurch gekennzeichnet,**
**dass** sich der erste Buffer [5] und/oder der zweite Buffer [6] auf dem Halbleiterchip befinden bzw. befindet und durch, vom Rest des Halbleiterchips getrennt angeschlossene, Versorgungsspannungsleitungen versorgt werden/wird.

3. Delta-Sigma Analog-/Digital-Wandler nach Anspruch 1, **dadurch gekennzeichnet,**
**dass** der erste Buffer und/oder der zweite Buffer jeweils ein externer Buffer [7,8] ist, deren/dessen Betriebsspannung getrennt von der Betriebsspannung für die digitalen Schaltungsteile des Halbleiterchips stabilisiert wird,damit eine Entkopplung zwischen Halbleiterchip und analogem Frontend eintritt.

4. Delta-Sigma Analog-/Digital-Wandler nach Anspruch 1, **dadurch gekennzeichnet,**
**dass** die über den Rückkopplungswiderstand [2] zurückgeführte Ausgangsspannung des D-Flip-Flops [4] frequenzmäßig deutlich unter der Abtastfrequenz dieses D-Flip-Flops liegt, wobei dieses Verhalten durch entsprechende Dimensionierung des Rückkopplungswiderstands [2] und der Integrator-Kapazität [3] erreicht wird.

5. Delta-Sigma Analog-/Digital-Wandler nach Anspruch 1, **dadurch gekennzeichnet,**
**dass** die über den Rückkopplungswiderstand [2] zurückgeführte Ausgangsspannung des D-Flip-Flops [4] frequenzmäßig deutlich unter der Abtastfrequenz dieses D-Flip-Flops liegt, wobei dieses Verhalten durch minimale interne Mitkopplungen im Signalpfad, was zu einer geringen Hysterese führt, erreicht wird.

6. Delta-Sigma Analog-/Digital-Wandler nach Anspruch 1, **dadurch gekennzeichnet,**
**dass** die Abtastfrequenz für das D-Flip-Flop [4] einem nicht frequenzstabilisierten Oszillator entnommen wird.

## Claims

1. A delta-sigma analog/digital converter, the analog front end of which consists of an input resistor [1], a feedback resistor (2) and an integrator capacitance [3], wherein said converter features a D-flip-flop [4] on a semiconductor chip, **characterized in**
**that** a first buffer [5][7] situated upstream of the D-input of the D-flip-flop [4] and/or a second buffer [6][8] situated downstream of the output of the D-flip-flop [4] is/are supplied with an operating voltage separately of the digital circuit components that are situated on the semiconductor chip in order to decouple the semiconductor chip from the analog front end.

2. The delta-sigma analog/digital converter according to Claim 1, **characterized in**
**that** the first buffer [5] and/or the second buffer [6] is/are situated on the semiconductor chip and supplied via voltage supply lines that are connected separately of the remainder of the semiconductor chip.

3. The delta-sigma analog/digital converter according to Claim 1, **characterized in**
**that** the first buffer and/or the second buffer respectively consists of an external buffer [7, 8], the operating voltage of which is stabilized separately of
the operating voltage for the digital circuit components of the semiconductor chip in order to decouple the semiconductor chip from the analog front end.

4. The delta-sigma analog/digital converter according to Claim 1, **characterized in**
**that** the frequency of the output voltage of the D-flip-flop [4] that is returned via the feedback resistor [2] lies well below the sampling frequency of this D-flip-flop, wherein this characteristic is achieved with corresponding ratings of the feedback resistor [2] and the integrator capacitance [3].

5. The delta-sigma analog/digital converter according to Claim 1, **characterized in**
**that** the frequency of the output voltage of the D-flip-flop [4] that is returned via the feedback resistor [2] lies well below the sampling frequency of this D-flip-flop, wherein this characteristic is achieved with minimal internal positive feedbacks in the signal path that lead to a reduced hysteresis.

6. The delta-sigma analog/digital converter according to Claim 1, **characterized in**
**that** the sampling frequency for the D-flip-flop [4] is obtained from an oscillator that is not frequency-stabilized.

## Revendications

1. Convertisseur analogique / digital Delta-Sigma, dont le côté frontal analogique est constitué d'une résistance d'entrée [1], d'une résistance de rétroaction [2] et d'une capacité de circuit d'intégration [3], comprenant un flip-flop D [4] sur une puce semi-conductrice, **caractérisé en ce que**,
un premier buffer [5][7] situé devant l'entrée D du flip-flop D [4] et/ou un deuxième buffer [6][8] situé après la sortie du flip-flop D [4] est/sont alimenté(s) en tension de fonctionnement séparément des parties de circuit digitales situées sur la puce semi-conductrice, afin de réaliser un découplage entre la puce semi-conductrice et le côté frontal analogique.

2. Convertisseur analogique / digital Delta-Sigma selon la revendication 1,
**caractérisé en ce que**,
le premier buffer [5] et/ou le deuxième buffer [6] se trouve(nt) sur la puce semi-conductrice et est/sont alimenté(s) par des lignes de tension d'alimentation connectées séparément du reste de la puce semi-conductrice.

3. Convertisseur analogique / digital Delta-Sigma selon la revendication 1,
**caractérisé en ce que**,
le premier buffer [5] et/ou le deuxième buffer [6] consistent consiste(nt) respectivement en un buffer externe [7,8], dont la tension de fonctionnement est stabilisée séparément de la tension de fonctionnement destinée aux parties de circuit digitales de la puce semi-conductrice, afin d'obtenir un découplage entre la puce semi-conductrice et le côté frontal analogique.

4. Convertisseur analogique / digital Delta-Sigma selon la revendication 1,
**caractérisé en ce que**,
la tension de sortie du flip-flop D [4] reconduite par l'intermédiaire de la résistance de rétroaction [2] se situe quant à sa fréquence nettement au-dessous de la fréquence de détection de ce flip-flop D, ce comportement pouvant également être obtenu par des dimensions correspondantes de la résistance de rétroaction [2] et de la capacité du circuit d'intégration [3].

5. Convertisseur analogique / digital Delta-Sigma selon la revendication 1,
**caractérisé en ce que**,
la tension de sortie du flip-flop D [4] reconduite par l'intermédiaire de la résistance de rétroaction [2] se situe quant à sa fréquence nettement au-dessous de la fréquence de détection de ce flip-flop D, ce comportement pouvant également être obtenu par des co-couplages internes minimaux dans le trajet des signaux, ce qui entraîne une légère hystérésis.

6. Convertisseur analogique / digital Delta-Sigma selon la revendication 1,
**caractérisé en ce que**,
la fréquence de détection pour le flip-flop D [4] peut être fournie par un oscillateur à fréquence non stabilisée.
